Europäisches Patentamt

European Patent Office

Office européen des brevets

(19)

(11) Publication number: **0 160 202**

**A2**

(12)

# EUROPEAN PATENT APPLICATION

(21) Application number: **85103296.1**

(22) Date of filing: **21.03.85**

(51) Int. Cl.⁴: **C 23 C 30/00**
**//C23C16/50, C23C14/34**

(30) Priority: **30.04.84 US 605033**

(43) Date of publication of application:
**06.11.85 Bulletin 85/45**

(84) Designated Contracting States:
**AT BE CH DE FR GB IT LI LU NL SE**

(71) Applicant: **ENERGY CONVERSION DEVICES, INC.**
**1675 West Maple Road**
**Troy Michigan 48084(US)**

(72) Inventor: **Hudgens, Stephen J.**
**2 Alexandria Town**
**Southfield Michigan 48075(US)**

(72) Inventor: **Johncock, Annette G.**
**244 South Pontiac Trail**
**Walled Lake Michigan 48088(US)**

(74) Representative: **Müller, Hans-Jürgen, Dipl.-Ing. et al,**
**Müller, Schupfner & Gauger Lucile-Grahn-Strasse 38**
**Postfach 80 13 69**
**D-8000 München 80(DE)**

(54) **Microwave plasma deposition of coatings and the microwave plasma applied coatings applied thereby.**

(57) Disclosed is a method of forming hard coatings on metallic substrates by microwave excited and maintained plasma deposition.

EP 0 160 202 A2

Croydon Printing Company Ltd

-1-

MICROWAVE PLASMA DEPOSITION OF COATINGS
AND THE MICROWAVE PLASMA APPLIED COATINGS
APPLIED THEREBY

FIELD OF THE INVENTION

This invention relates to coatings, and more particularly, to substantially chemically inert, corrosion resistant, non-reactive, thermally stable coatings, i.e. refractory coatings, on surfaces that are subjected to friction, build up, or wear, to coatings for tools utilized for cutting, forming and grinding, to roller surfaces used for making sheet, p ate bar and tubes, and to high luster decorative coatings.

BACKGROUND OF THE INVENTION

Tools have been fabricated to achieve various standards of hardness, lubricity, and wear-resistance. Similarly roller surfaces have been fabricated to resist build up, and process equipment has been fabricated to resist corrosion. This has been accomplished by control of the chemical composition and thermal history of the tool, roll, or

-2-

container and of the tool, roll or container surface. For example, tools for working and shaping unhardened steels may be fabricated from steel containing enough carbon to form martensite. For other applications, changing the carbon content and adding various alloying agents gives properties making possible nondeforming steels, shock resistant steels, hot work steels and high speed steels. Suitable alloying elements include carbide forming metals such as titanium, vanadium, molybdenum, tungsten and chromium, all of which impart wear-resistance and hardness.

An alternative way of obtaining desirable tool or wear properties is through the use of surface coatings. These surface coatings may improve hardness and/or lubricity of the tool. Surface coatings are especially useful where it is desired to lengthen tool life or where it is necessary to shape and work hardened steel.

Many types of wear-resistant coatings of the prior art require high temperatures for application. The use of high temperatures makes these coatings impractical on many substrate materials. This is because the properties of the substrate may change significantly during the elevated temperature application of the coating. Other types of coatings do not adhere to the substrate under working conditions. Thus, a need exists for wear-resistant coatings that can be applied at relatively low temperatures to avoid significant change of substrate properties. A need exists for wear-resistant coatings for articles such as tools to provide improved properties of hardness and lubricity thereby resulting in longer tool life and improved surface finish of the parts machined therewith. A need also exists for wear-resistant coatings that have improved adhesion properties and resistance to failure.

In a like manner, a need exists for build up resistant surfaces for rolls. Build up is the development of nodules of iron, iron oxides, and mixtures thereof on roll surfaces. Build up appears to be correlated to a relative speed difference between the roll and the steel at temperatures above about 350°C. Build-up results in deterioration of the rolled steel product. A need exists for build up resistant coatings for rolls, which coating must be chemically passivating, and resistant to the build-up of corrosion products and grinding products.

Similarly, a need exists for decorative coatings that have high luster and reflectivity, good adhesion, good resistance to oxidation and corrosion, and ease of application. The decorative coatings are used on various metal objects including automobile bumpers, automobile trim, plumbing fixtures, household appliances, metal furniture and the like.

## SUMMARY OF THE INVENTION

It has now been found that coatings hereinafter referred to as refractory coatings, of disordered materials deposited by microwave excited and maintained plasmas provide excellent resistance to wear, high lubricity, oxidation resistance, corrosion resistance, build up resistance high luster, and high reflectivity. Tools, rolls, and other articles which are subject to wear, for example as the result of contact with other surfaces, can be coated with disordered materials by microwave excited and maintained plasmas whereby to increase the useful life

-4-

of the tool, roll or article. When the word "tool" is used herein, it is intended to also encompass rolls. The contemplated coatings contain alloys, compounds and non-stoichiometric compounds of Group IIIB and Group IVB elements with nitrogen, phosphorous, oxygen, carbon, and boron. Exemplary compounds, including non-stoichiometric compounds of Group III and Group IV include boron carbides, boron silicides, silicon borides, silicon carbides, silicon oxides, germanium carbides, germanium silicides, germanium nitrides, germanium oxides, germanium borides, aluminum oxides, and aluminum nitrides. Optionally, the coating may contain a transition metal component or an alloy thereof where, by an alloy, is meant that the coating can contain more than one transition metal.

The tool coating is deposited from a microwave excited and maintained plasma. The plasma may be a glow discharge plasma or a reactive sputtering plasma. The microwave excited and maintained plasma provides a high density of free radicals, a high deposition rate and a high deposition gas utilization. Moreover, the microwave excited and maintained plasma provides a higher electron temperature relative to an r.f. excited and maintained plasma, in this way the microwave excited and maintained plasma provides more ions in the microwave plasma relative to the number of ions in a radio frequency plasma. This results in higher deposition rates, i.e., from about 10 to 250 or more angstroms per second. This is 1 to 2 orders of magnitude higher than the deposition rate obtained with r.f. assisted glow discharge deposition. In the contemplated microwave plasma deposition process, the glow discharge deposition gas, that is the reactive gas, is passed through a reaction tube or reaction chamber or vacuum chamber and decomposed by microwave energy to form a plasma. Alternatively, the plasma may include both reactive gas and metal ions as in microwave reactive sputtering.

According to the process herein contemplated, the reaction gas mixture, for example a mixture of gases such as silane, fluorosilanes, germane, borane, phosphine, ammonia, nitrogen, oxygen, hydrocarbons such as methane or ethane, and/or organometallic compounds as aluminum alkyls, are introduced into the vacuum chamber. Within the vacuum chamber, an initial vacuum of less than $10^{-5}$ torr is initially established and thereafter the vacuum chamber is pressurized with reaction gas to a pressure of from about $10^{-2}$ torr to $10^{-1}$ torr. A source of microwave radiation is provided and coupled to the reaction vessel. The reaction gas is introduced into the reaction chamber in the presence of microwave radiation whereby to form a plasma. The microwave radiation is generated from a source, for example, a microwave frequency magnetron having a frequency of from about 2.45 gigahertz. A wave guide is operatively in series with the source, and probes are spaced from the reaction chamber walls as wave guides. The wave guides serve to maximize coupling of the microwave energy from the probes and such energy is radiated by the probes. The microwave energy serves to generate ions, free radicals, atoms, and various other unstable and metastable species, i.e., a plasma.

Tools that have been microwave plasma coated in accordance with the invention have excellent hardness and lubricity characteristics which result in increased lifetimes, and depending on the particular application thereof, improved surface finishes on the products machined therewith.

Decorative items microwave plasma coated in accordance with the invention have high reflectivity and are characterized by corrosion resistance, oxidation resistance, and other desirable properties.

The disordered wear-resistant coatings may be amorphous, polycrystalline and lacking in long range compositional order, microcrystalline and lacking in long range compositional order, or a mixture or combination of amorphous, polycrystalline, and/or microcrystalline phases. Additionally, while the coatings are referred to as being disordered, it is to be understood that there may be polycrystalline, microcrystalline or crystalline inclusions therein.

The coating compositions may be stoichiometric or nonstoichiometic, and may encompass thermodynamically unstable or thermodynamically metastable phases which are deposited at the high quench rates associated with plasma deposition processes onto a low temperature substrate, for example, plasma deposition processes resulting in a temperature drop of from about $10^6$ to about $10^8$°C per second. The coatings of the present invention are disordered coatings and are formed as disordered coatings. Without wishing to be bound by this explanation, it is believed that the disordered wear-resistant coatings, corrosion resistant coatings, and oxidation resistant coatings perform better than single phase crystalline coatings in that they are charcterized by the substantial absence of crystal defects, e.g., slip planes, edge dislocations, screw dislocations, grain boundaries, and the like, which serve as a site for the initiation or propagation of fracture, corrosion, oxidation or the like. Moreover, plasma deposited disordered coatings may be more susceptable than the single phase crystalline coatings to diffusive bonding between a substrate surface and the coating, resulting in superior adhesion or adherence.

Disordered materials lack the extended crystalline lattice planes, slip planes, edge dislocations, screw dislocations, and other defects associated therewith through which fractures can propagate and, in general, disordered materials can withstand relatively high deformation forces without fracture.

Disordered materials are less susceptable to corrosion or oxidation of the types associated with crystal defects and grain boundaries than single phase crystalline materials because of the absence of crystal defects and grain boundaries which can serve as a site for initiation or propagation of corrosion or oxidation.

It is believed that the foregoing advantages associated with substantially disordered coatings formed of thermodynamically unstable or metastable materials are more fully realized with the microwave plasma deposited coatings herein contemplated.

The microwave plasma deposited, thermodynamically unstable and/or thermodynamically metastable wear-resistant coatings utilized can have compositions tailor made to achieve desired characteristics while avoiding the formation of extended lattice planes which diminish wear-resistance, oxidation resistance, and corrosion resistance properties of the coating.

A further advantage of the coatings herein contemplated is that the coatings can be applied to a substrate, for example a tool surface or other surface without significantly changing the dimensions of the substrate since the thickness of the coating is on the order of angstroms to about 1000 microns and can be relatively closely controlled. After a tool or other substrate with or without the coating has been in use, the coatings herein contemplated may be applied thereto whereby to achieve a desired mechanical or fit tolerance or to replace a coating that has been worn from the tool. Thus, according to the invention herein contemplated, tools may be reclaimed that would otherwise be discarded.

In accordance with a further exemplification of the present invention, a composite coating may be utilized in which a first layer or adherence layer different from the decorative, wear-resistant, abrasion resistant, corrosion resistant, or oxidation resistant layer in morphology or chemical composition is applied to the substrate. The adhesion layer improves the adherence of the disordered layer which is applied atop the adhesion layer. Generally the adhesion layer may be vapor deposited, reactive sputter deposited, sputter deposited, r.f. glow discharge deposited, microwave glow discharge deposited, or the like, and may be formed of any material which improves the adherence of the disordered hard coating herein contemplated without adversely affecting the wear-resistant, oxidation resistant, corrosion resistant, or reflective properties thereof to a significant degree.

The adherence coating may be stoichiometric or nonstoicheiometric and disordered or nondisordered. Generally, suitable compounds for the adherence coatings include oxides, borides, carbides, and nitrides of those transition metals which readily form a plurality of oxidation states, such as titanium, vanadium, and iron. Especially preferred are titanium oxide and titanium nitride.

In accordance with another exemplification of the invention, stress relieving layers may be applied between layers of the disordered, hard coating material. Such stress relieving layers are believed to allow some tribological flow between layers or provide a soft intermediate or intervening layer whereby to avoid stress fracture of the hard coating.

## DETAILED DESCRIPTION OF THE INVENTION

The substantially chemically inert, thermally stable wear-resistant build up resistant coatings formed in accordance with the present invention are deposited from a microwave excited and maintained plasma and advantageously are thermodynamically unstable or thermodynamically metastable disordered materials.

Prior to microwave plasma deposition, it may be important to provide an atomically clean surface on the portion of the tool substrate or article that is to be coated. As used herein, the term "substrate" means that portion of the tool, substrate, or article exclusive of the coating or coatings applied in accordance with the invention.

Cleaning, degreasing, or etching the surface permits the formation of a uniform coating which adheres to the surface without intervening grease, dirt, or oxide. There are several methods known to those skilled in the art for providing an atomically clean surface for plasma deposition and any one or more of the methods may be utilized. In accordance with one method of providing an atomically clean surface, the tool is degreased with a chlorinated hydrocarbon degreaser. Thereafter, the tool is rinsed in methanol. The tool is either plasma or acid etched. When plasma etching is utilized, preferably a fluorinated carrier gas such as carbon tetrafluoride is used. The carrier gas decomposes and provides fluorine which cleans the surface of a tool.

Alternatively, the tool may be acid etched, for example, acid etched in an oxidizing acid and a mineral acid as in a mixture of nitric acid and hydrochloric acid or a mixture of hydrochloric acid and sulfuric acid whereby to remove any oxide film which may be formed thereon and prevent the formation of a subsequent oxide film.

The final step for providing an atomically clean surface after plasma etching or acid etching is to sputter etch in an argon plasma. After an atomically clean surface has been provided on the tool or at least on that portion of the tool which is to be coated, the tool coating can be applied.

In accordance with the present invention, the hard, disordered coating is formed by a microwave established and maintained plasma.

In the microwave established and maintained plasma deposition process, a glow discharge deposition gas is passed to and through a vacuum chamber and decomposed by microwave energy to form a plasma. According to the process, the reaction gas mixture contains a reaction gas of two or more reactive gases, one chosen from the group consisting of silane, $Si_2H_6$, fluorosilane, germane, borane, or an aluminum alkyl, and another component chosen from the group consisting of phosphine, ammonia, nitrogen, oxygen, or a hydrocarbon as methane, or ethane or the like, or a mixture thereof.

The vacuum chamber is initially pumped down to an initial vacuum less than about $10^{-5}$ torr and thereafter, the reaction gas is introduced therein at a higher pressure but still less than $10^{-1}$ torr and preferably from about $10^{-2}$ to about $10^{-1}$ torr.

A source of microwave radiation, i.e. a magnetron, is provided in proximity to and coupled to the vacuum chamber. As the gas is introduced to form the plasma, a signal is generated in the magnitron source at a magnetron frequency, e.g. about 2.45 gigahertz. The signal is carried by a wave guide, operatively in series therewith, to probes. The probes are spaced from the vacuum chamber walls and wave guides.

In this way, a plasma is formed. By a plasma is meant a "gaseous" mixture of electrons, positive ions, negative ions, sputtered neutrally charged atoms, free radicals and the like all existing in a glowing region. The deposition rate is from about 10 to 200 angstroms per second, depending on the metals and metalloids being deposited.

757

0160202

-12-

Generally, if the coating is a tool coating, it is from about 50 angstroms to about 1000 microns thick. Alternatively, where the coating is a corrosion resistant coating or oxidation resistant coating it is also from about 50 angstroms to about 1000 microns thick. Where the coating is a decorative coating, it is from about 20 angstroms to about 50 microns thick whereby to allow the underlying reflectivity of the substrate to be visible therethrough. However, the above thicknesses merely describe the preferred exemplifications and are not limitations on the invention. Accordingly, thicker or thinner coatings may be utilized to provide the desired results for a particular application.

The coatings formed according to the described method include disordered silicon oxides, disordered silicon nitrides, disordered silicon carbides, disordered silicon borides, disordered boron nitrides, disordered boron carbides, disordered aluminum oxides, disordered aluminum nitrides, disordered germanium oxides, disordered germanium nitrides, disordered germanium silicides, and disordered germanium carbides.

While it is anticipated that the herein contemplated coatings which are not "disordered" as defined above can also be used as wear-resistant coatings, build up resistant coatings, corrosion resistant coatings, or oxidation resistant coatings, it is believed that disordered materials provide superior coatings. Moreover, while coatings having compositions outside the above described ranges may be utilized, it is believed that the best combinations of adherence, physical strength, hardness, lubricity, corrosion resistance, oxidation resistance, and the

-13-

like is achieved with coatings having compositions roughly within the above described ranges.

The herein contemplated coatings are refractory coatings, that is, they are substantially resistant to oxidation, corrosion, build up, and thermal degradation.

As used throughout this specification, the term "lubricity" includes: (1) a measure of friction between a tool and a work piece, i.e., the more "lubricous" a coating is, the less friction there is between the tool and the work piece; (2) the absence of edge build up, i.e., the more lubricous a coating is, the less of a tendency there is for chips and particles from the work piece to adhere to the tool surface; and (3) the surface effect at the interface between the tool and the work piece where the coating on the surface of the tool forms a region at the edge of the work piece, that is compositionally different than the work piece as by diffusion of a portion of the coating into a work piece edge thereby facilitating removal of material from the work piece by the tool.

Thus, in accordance with one aspect of this invention, the desired lubricity of a tool is achieved by controlling the ratio of the components present in the surface, as by increasing the amount of boron in the hard surface thereby to increase the lubricity.

Generally, the hardness of the coatings in accordance with the present invention is greater than about 1500 Knoop. Since the hard, microwave plasma deposited, disordered coatings are relatively thin, direct measurement of Knoop hardness is impractical.

-14-

The Knoop hardness is reported is the Knoop hardeness of the crystalline material. However, the Brinnel hardness, the Rockwell hardness, and Taber abrasion resistance of the disordered materials prepared by microwave plasma deposition are generally higher than those of the compositionally analogous crystalline materials. Moreover, in addition to being hard, the microwave plasma deposited materials exhibit excellent lubricity. Accordingly, tools and rolls made in accordance with the present invention have increased life and the use of such tools can result in an improved surface finish on parts machined therewith or rolled thereon.

In accordance with a still further exemplification of the invention, the coatings prepared by the microwave plasma deposition process herein contemplated are characterized by a high corrosion resistance and oxidation resistance. It is believed that this is due to the absence of crystal planes and crystal phases which may act as sites for selective diffusion of oxidizing or corroding species therein while allowing for a hard surface. By "corrosion resistance" and "oxidation resistance" is meant the reduction in weight change, measured in milligrams per square centimeter per year, when exposed to a controlled environment.

In accordance with a further exemplification of the invention, a composite coating having high adhesion or adherence on a substrate is provided. The coating is prepared by first providing a coating of an adherence or adhesion promoting material different in structure or composition from the microwave plasma deposited hard coating. The adherence coating is applied to the substrate and improves the adherence of

-15-

the microwave deposited hard coatings described hereinabove. Any coating which improves the adherence of the microwave plasma deposited hard coating and does not significantly adversly effect the properties thereof can be utilized. The adherence coating is at least about 500 angstroms thick, and generally greater than or equal to about 500 to 10,000 angstroms in thickness and may be amorphous, microcrystalline, polycrystalline, crystalline or any combination thereof.

Generally the adherence coating is vapor deposited, for example, by sputtering, reactive sputtering, r.f. plasma deposition, or microwave plasma deposition, although low temperature chemical vapor deposition may be utilized. After application of the adherence coating the microwave plasma deposited hard coating may be applied thereon.

According to one exemplification the adherence coating may be deposited by reactive sputtering in an oxygen, nitrogen, or phosphine containing atmosphere, with a suitable metal target. Suitable metals are those which may be utilized to form the adherence coating as described below.

Preferably the adherence coating contains an element or component which has a high atomic mobility, as boron, carbon, nitrogen, oxygen or mixtures thereof, and a carrier component, preferably a transition metal capable of forming a plurality of stable oxidation states. The combination of atoms with high mobility and transition metals capable of forming a plurality of stable oxidation states allows the diffusion of the high mobility atoms into both the substrate and the microwave deposited hard coating

757

allowing the adherence coating to maintain its integrity while forming bonds with both the substrate and the microwave deposited hard coating.

The herein contemplated adherence coating, when utilized, is a coating of a non-metallic material chosen from the group consisting of oxygen, nitrogen, carbon, boron, and mixtures thereof, and a transition metal capable of forming a plurality of stable oxidation states, and chosen from the group consisting of titanium, vanadium, iron, and mixtures thereof. Exemplary is titanium carbide containing from about 50 to about 68 atomic percent titanium and from about 32 to about 50 atomic percent carbon, and having a titanium carbide structure. According to a still further exemplification, the adherence coating may be a coating of titanium oxygen applied, for example by reactive sputtering and containing from about 50 to about 66 atomic percent titanium and from about 34 to about 50 atomic percent oxygen. Nonstoicheiometric composition of titanium and oxygen are particularly preferred in the range of from about 50 to about 66 atomic percent oxygen.

When the adherence coating is utilized between the substrate and the herein contemplated microwave plasma deposited hard coating, the adherence coating may be applied by forming an adhesion layer on the atomically clean substrate as by reactive sputtering, sputtering or the like and thereafter forming the coating atop the adhesion layer as described hereinabove.

According to a still further exemplification of the invention, especially where the coating is more than about 5 microns thick, there may be provided a stress relieving layer between a pair of individual layers of the microwave plasma deposited hard coating. Thus a stress relieving layer may be applied atop an individual layer of microwave plasma deposited hard coating and thereafter a further microwave deposited layer of hard coating material may be applied atop the stress relieving layer.

As herein contemplated, the stress relieving layer may be a sputtered, reactively sputtered, r.f. plasma deposited, or microwave deposited coating of a transition metal or oxide, nitride, or carbide thereof. Exemplary are layers of deposited niobium compounds or zirconium compounds. The stress relieving layers are at least about $10^3$ angstroms thick. In this way, thick hard layers of up to about 1000 microns may be prepared which layers have enhanced abrasion, resistance, wear resistance, build up resistance, and chemical stability and inertness.

Thus, according to one exemplification of the invention, there is provided a tool having a substrate, as a mild steel substrate, and a coating thereon comprising a disordered refractory composition of a first component chosen from the group consisting of boron, aluminum, silicon, germanium, and mixtures thereof, and a second component chosen from the group consisting of carbon, nitrogen, oxygen and mixtures thereof, for example as silicon carbide, silicon nitride, silicon oxide, boron carbide, boron nitride, aluminum oxide, aluminum nitride, germanium carbide, germanium nitride, or germanium oxide. The coating is deposited from a microwave excited plasma as described above and it generally has a thickness of from about 50 angstroms to about 1000 microns. The coating may further be characterized by the presence of an

-18-

adhesion or adherence promoting layer, for example, a layer of a nonstoichiometric titanium oxide, titanium boride, vanadanium oxide or the like, between the tool or roll substrate and the hard coating  Moreover, the refractory, microwave plasma deposited coating may itself be a plurality of individual coatings, each from about 50 angstroms to about 1000 microns thick and having stress relieving layers, films, or coatings of a zirconium or niobium compound of about 1000 angstroms to about 1000 angstroms thick therebetween.

The above described coatings are characterized by lubricity, abrasion resistance, hardness, corrosion resistance and oxidation resistance.

While the invention has been described with respect to certain exemplifications and embodiments thereof, it is not intended to limit the scope of the invention thereby but solely by the claims appended hereto.

Energy Conversion Devices, Inc.
757
H.JM/kh

## Claims
=======

1. Coated metal article, especially tool comprising a substrate and a coating thereon,
characterized in
that the coating comprises a disordered, refractory composition of a first component chosen from the group consisting of B, Al, Si, Ge, and mixtures thereof, and a second component chosen from the group consisting of C, N, O and mixtures thereof.

2. Coated metal article as claimed in claim 1, wherein the first component is boron and the second component is chosen from the group consisting of nitrogen, carbon, and mixtures thereof.

3. Coated metal article as claimed in claim 1, wherein the first component is silicon and the second component is chosen from the group consisting of nitrogen, oxygen and carbon.

4. Coated article as claimed in claim 1, wherein the first component i aluminium and the second component is chosen from the group consisting of nitrogen and oxygen.

5. Coated article as claimed in claim 1, wherein the first component is germanium, and the second component is chosen from the group consisting of nitro-

gen, carbon, oxygen, and boron.

6. Coated metal article as claimed in any of the preceding claims,
wherein the coating thickness is between about 5 x $10^{-3}$ and about 1000 microns.

7. Coated metal article as claimed in any of the preceding claims,
characterized by an adhesion layer between the substrate and a hard coating.

8. Coated metal article as claimed in claim 7,
wherein the adhesion layer comprises a high atomic mobility component and a transition metal component.

9. Coated metal article as claimed in claim 8,
wherein the high atomic mobility component is chosen from the group consisting of oxygen, nitrogen, carbon, boron, and mixtures thereof, and wherein the transition metal component is chosen from the group consisting of titanium, vanadium, carbon, and combinations thereof.

10. Coated metal article as claimed in any of the preceding claims,
characterized in that a stress relieving layer is formed atop a hard coating layer, wherein another hard coating layer is formed atop the stress relieving layer.

11. Coated metal article as claimed in claim 10,
wherein the stress relieving layer is formed of a composition chosen from the group consisting of borides, carbides, nitrides, and oxides of niobium, zirconium, and mixtures thereof.

12. Method of forming a coating on a substrate of a coated metal article, in particular a tool, as claimed in one of the preceding claims, characterized in that the coating, the adhesion layer and/or the stress relieving layer is deposited from a microwave excited plasma and/or by reactive sputtering.

13. Method as claimed in claim 2, characterized by the following method steps:

(1) placing the substrate in a vacuum chamber having reactive gas entry means and magnetron microwave energy excitation means;

(2) maintaining a total pressure less than $10^{-5}$ torr within the vacuum chamber;

(3) introducing a two component reactive gas into the vacuum chamber, said reactive gas having one component chosen from the group consisting of $B_2H_6$, $SiH_4$, $GeH_4$, and mixtures thereof, and a second component chosen from the group consisting of $N_2$, $O_2$, hydrocarbons, especially $NH_3$, and mixtures thereof, and

(4) forming a plasma of the reactive gas whereby to deposit the coating on the substrate.

14. Method as claimed in claim 13, characterized by the following method steps:
drawing an initial vacuum less than $10^{-5}$ torr into the vacuum chamber, and thereafter introducing gas, especially at first inert gas and thereafter reactive gas, into the vacuum chamber at a higher pressure, less than $10^{-1}$ torr.

15. Use of a coated metal article as claimed in any of the claims 1 - 11 as a tool of high wear-resistance.

16. Use of a coated metal article as claimed in any of the claims 1 - 11 as a roll of high wear-resistance.